# FASCICULE DE BREVET EUROPEEN

(11) **EP 3 312 622 B1**
(45) Date de publication et mention de la délivrance du brevet: **21.11.2018**
(21) Numéro de dépôt: 17194631.2
(22) Date de dépôt: 03.10.2017
(51) Int. Cl.: G01R 31/12, G01R 31/02, G01R 31/08, H01B 17/56, H02G 7/00

(54) **ISOLATEUR POUR LIGNES ELECTRIQUES AERIENNES AVEC UN DETECTEUR DE COURANT DE FUITE PROTEGE**
ISOLATOR FÜR ELEKTRISCHE OBERLEITUNGEN MIT EINEM GESCHÜTZTEN STROMLECKDETEKTOR
INSULATOR FOR OVERHEAD POWER LINES WITH A PROTECTED LEAKAGE CURRENT DETECTOR

(30) Priorité: 18.10.2016 FR 1660093
(43) Date de publication de la demande: 25.04.2018
(73) Titulaire: Sediver SA, 92017 Nanterre (FR)
(72) Inventeur: MESPLES, Fabrice, 03700 BELLERIVE SUR ALLIER (FR); COULLOUDON, François, 75015 PARIS (FR)
(74) Mandataire: Prugneau, Philippe

(56) Documents cités:
- EP-A1- 2 884 292
- US-A- 2 023 808
- US-A- 4 670 624

## Description

### Domaine technique

Le domaine de l'invention est celui des isolateurs pour lignes électriques à haute et très haute tension.

L'invention concerne en particulier un isolateur pour lignes électriques aériennes comprenant un élément diélectrique d'extrémité ayant une surface extérieure en forme de jupe et qui est prolongé par une armature métallique d'accrochage de l'isolateur, et un dispositif de détection de courant électrique de fuite superficiel circulant sur la surface extérieure de l'élément diélectrique comprenant un anneau métallique en contact électrique avec la surface extérieure de l'élément diélectrique pour intercepter le courant de fuite superficiel.

Il peut s'agir d'un isolateur de chaîne avec des éléments diélectriques par exemple en verre trempé de type capot/tige qui s'assemblent en chaîne ou encore d'un isolateur composite avec des éléments diélectriques du type ailette en un matériau synthétique moulé qui sont disposés en série autour d'une âme en fibre de verre et résine.

Il peut s'agir encore d'un isolateur rigide à fût avec des éléments diélectriques en porcelaine.

Ces isolateurs peuvent être montés en suspension sur un pylône pour soutenir en l'air une ligne électrique. Ils peuvent aussi servir d'ancrage à une ligne électrique.

### Technique antérieure

Il est connu que ces isolateurs pour lignes électriques aériennes sont soumis aux intempéries, pluie ou brouillard salin par exemple, et à la pollution de l'air, d'origine naturelle ou industrielle, et des grains de matière peuvent se déposer sur la surface extérieure des éléments diélectriques.

Lorsque la couche de saleté devient humide, elle se transforme en électrolyte conducteur ce qui peut donner naissance à un courant de fuite superficiel circulant en surface de l'isolateur.

Un courant de fuite élevé peut entraîner l'interruption de l'isolation électrique.

Ainsi, les industriels cherchent à détecter et mesurer les courants de fuite superficiels sur ce type d'installation.

Le document de brevet EP 2884292 présente un dispositif de détection des courants de fuite superficiels sur des isolateurs de chaîne en verre ou porcelaine du type capot/tige.

Ce dispositif comprend une unité de détection qui peut se monter sur le premier élément diélectrique de type capot/tige de la chaîne.

L'unité de détection comprend un premier anneau métallique qui se fixe autour du capot de ce premier élément diélectrique et qui est en contact avec la surface du diélectrique en verre par un treillis métallique.

L'unité de détection comprend encore un second anneau métallique de mise à la terre qui se fixe autour du capot au dessus du premier anneau et un boitier de mesure électronique relié aux deux anneaux métalliques conducteurs pour détecter et mesurer le courant de fuite.

Cet agencement présente l'inconvénient d'être lui aussi soumis à la pollution de l'air et des pluies, en particulier les anneaux métalliques qui se trouvent directement exposés aux conditions environnementales par exemple à la pluie.

Il en résulte que le dispositif de détection et de mesure des courants de fuite superficiels peut présenter des défaillances de détection et de mesure.

C'est pourquoi les fabricants d'isolateurs pour lignes électriques aériennes cherchent à développer des isolateurs comprenant des dispositifs de détection de courants de fuite superficiels qui soient plus fiables.

Les documents de brevet US2023808 et US4670624 concernent le problème des courants de fuite sur d'autres types d'isolateurs pour lignes électriques aériennes

### Exposé de l'invention

Le but de l'invention est donc de proposer un isolateur pour lignes électriques aériennes avec un dispositif de détection de courants de fuite superficiels amélioré.

A cet effet, l'invention a pour objet un isolateur pour lignes électriques aériennes comprenant un élément diélectrique d'extrémité ayant une surface extérieure en forme de jupe et qui est prolongé par une armature métallique d'accrochage de l'isolateur, et un dispositif de détection de courant électrique de fuite superficiel circulant sur la surface extérieure de l'élément diélectrique comprenant un anneau métallique en contact électrique avec la surface extérieure de l'élément diélectrique pour intercepter le courant de fuite superficiel, caractérisé en ce qu'il comprend un élément protecteur isolant électriquement en forme de douille à collerette, la douille de l'élément protecteur étant interposée entre l'anneau et l'armature et la collerette de l'élément protecteur s'étendant radialement pour surplomber l'anneau de façon à former une ombrelle de protection.

L'isolateur selon l'invention peut présenter les particularités suivantes :
- l'anneau peut être collé à la surface extérieure en forme de jupe de l'élément diélectrique avec une colle conductrice de courant ;
- l'élément protecteur peut être en éthylène-propylène diène monomère (EPDM) ou en silicone ;
- le dispositif de détection peut comprendre un transformateur du courant de fuite en tension ;
- le convertisseur peut être noyé dans l'élément protecteur ;
- le convertisseur peut être noyé dans l'armature métallique ;
- le convertisseur peut être déporté de l'isolateur ;
- l'élément diélectrique peut être en verre ;
- l'élément diélectrique peut être en porcelaine;
- l'élément diélectrique peut être en matériau synthétique ;
- la collerette de l'élément protecteur peut avoir une forme tronconique ;
- la collerette de l'élément protecteur peut être traversée de façon étanche par un câble électrique relié à l'anneau.

L'idée à la base de l'invention consiste donc à placer une sorte d'ombrelle au dessus de l'anneau conducteur qui capte les courants de fuite superficiels pour le protéger des pollutions environnementales ce qui permet de limiter les défaillances du dispositif de détection et de mesure des courants de fuite superficiels.

Comme indiqué plus haut, le dispositif de détection et de mesure comprend un convertisseur des courants de fuite détectés (de quelques milliampères) en tension pour faciliter la mesure analogique du signal.

L'élément de protection selon l'invention peut être vu comme un manchon souple et élastique qui peut s'enfiler par exemple sur le capot métallique du premier élément diélectrique d'une chaîne d'éléments diélectriques du type capot/tige.

L'élément de protection peut ainsi être posé en première ou en seconde monte. Ce montage ne modifie pas la longueur de la ligne de fuite de l'isolateur de chaîne de manière significative.

### Description sommaire des dessins

La présente invention sera mieux comprise et d'autres avantages apparaîtront à la lecture de la description qui suit et des dessins annexés dans lesquels :
- la figure 1 est une illustration schématique d'un isolateur de suspension selon l'invention du type capot/tige installé sur un pylône pour supporter une ligne électrique aérienne ;
- la figure 2 est une illustration schématique d'un élément diélectrique en verre de type capot/tige équipé d'un dispositif de détection de courant de fuite superficiel ;
- la figure 3A montre en coupe axiale l'élément diélectrique de la figure 2 ;
- la figure 3B montre plus en détail en coupe axiale l'anneau conducteur avec l'élément protecteur en forme de douille à collerette ;
- la figure 4 illustre schématiquement un boitier de conversion du courant de fuite en tension qui est noyé dans l'élément protecteur en forme de douille à collerette ;
- la figure 5 illustre schématiquement un boitier de conversion du courant de fuite en tension qui est noyé ou incrusté en surface dans le capot métallique de l'élément diélectrique du type capot/tige à l'arrière de l'élément protecteur ;
- la figure 6 illustre un isolateur composite selon l'invention équipé d'un dispositif de détection de courant de fuite protégé par un élément protecteur en forme de douille à collerette.

### Description des modes de réalisation

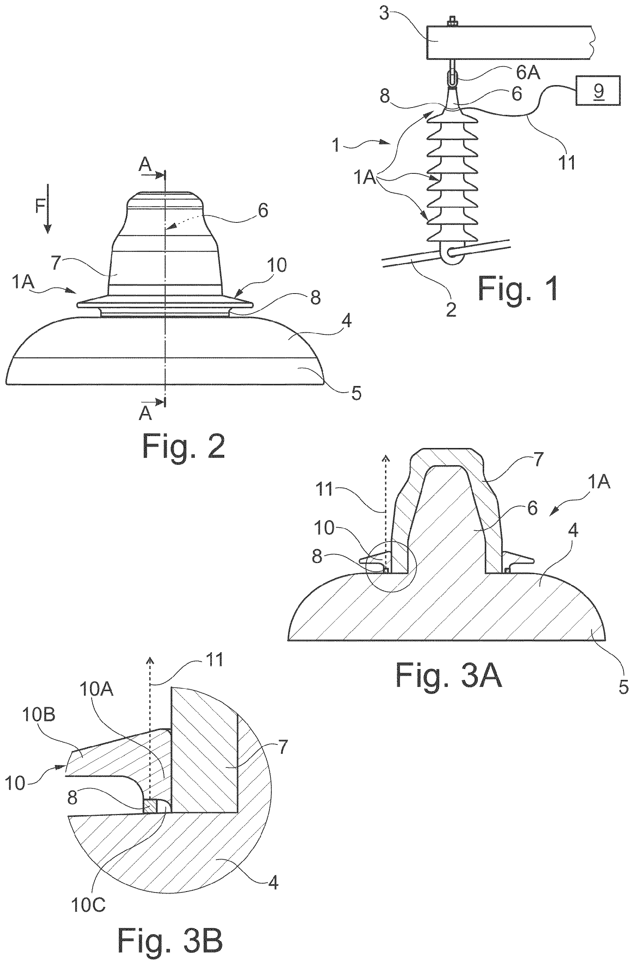

La figure 1 illustre ici de façon schématique un isolateur 1 de suspension avec des éléments diélectriques 1A en série et qui soutient en l'air une ligne électrique aérienne 2 haute tension à un pylône 3.

Sur la figure 1, l'isolateur 1 comprend ici à titre d'exemple une série de huit éléments diélectriques 1A.

L'élément diélectrique 1A à l'extrémité supérieure de l'isolateur 1 est équipé d'un anneau 8 métallique pour capturer le courant de fuite superficiel circulant en surface du diélectrique 1A et d'un boitier électronique 9 de détection et de mesure de ce courant de fuite résiduel relié à l'anneau 8 par un câble électrique 11.

Le boitier électronique 9 peut être fixé par exemple au pylône 3.

Les valeurs de mesure peuvent ensuite être par exemple transmises du boitier 9 par ondes radioélectriques vers une station distante de contrôle non représentée.

L'invention s'applique à différentes sortes d'isolateurs pour lignes électriques aériennes comme des isolateurs de chaîne du type capot/tige avec des éléments diélectrique en verre ou porcelaine ou des isolateurs rigides en porcelaine ou encore des isolateurs composites.

Sur la figure 2, on a illustré ici à titre d'exemple uniquement un élément diélectrique 1A d'extrémité d'un isolateur 1 de chaîne du type capot/tige qui comprend un isolant 4 en verre trempé dont la surface extérieure forme une sorte de jupe ou cloche 5 à ligne de fuite allongée.

L'isolant 4 présente une tête creuse 6 sur laquelle est scellé un capot 7 métallique en fonte galvanisée qui est prolongé ici axialement par une armature métallique d'accrochage 6A de l'isolateur 1 venant se fixer au pylône 3. Ici, pour cet élément diélectrique 1A d'extrémité, le capot 7 fait partie de l'armature d'accrochage 6A.

Une tige (non représentée) en acier galvanisé est scellée à l'intérieur de la tête creuse 6. Cette tige s'étend axialement selon l'axe A et est destinée à s'emboîter dans le capot 7 de l'élément diélectrique 1A adjacent à l'élément diélectrique 1A d'extrémité.

Sur la figure 2, on a représenté l'anneau métallique 8 entourant le capot 7 métallique et qui est protégé par un élément protecteur 10 en forme de douille à collerette et qui forme une sorte d'ombrelle de protection pour l'anneau 8.

Sur les figures 3A et 3B, on a représenté plus en détail l'anneau 8 avec l'élément protecteur 10.

Comme visible sur ces figures, l'anneau 8 est une bague métallique électriquement conductrice qui est posée de façon coaxiale suivant l'axe A sur la surface extérieure de l'isolant en verre 4 de telle façon à intercepter le courant de fuite superficiel qui circule en surface de l'isolant en verre 4.

Comme visible sur la figure 3B, la douille 10A de l'élément protecteur 10 s'étend axialement le long du capot 7.

Elle est interposée à son extrémité la plus basse entre l'anneau 8 et le capot 7 de sorte que l'anneau 8 n'est pas en contact électrique avec le capot 7.

La collerette 10B de l'élément protecteur 10 s'étend radialement vers l'extérieur en surplomb de l'anneau 8 de sorte à former une sorte d'ombrelle de protection empêchant le dépôt de saleté et d'humidité sur l'anneau 8.

Sur les figures 3A et 3B on a illustré le câble électrique 11 qui relie l'anneau 8 au boitier électronique 9.

L'anneau 8 a ici une section carrée mais pourrait aussi avoir une section rectangulaire ou analogue.

L'anneau 8 a une base annulaire plate qui est directement en contact avec la surface extérieure de l'isolant en verre 4.

L'anneau 8 peut être avantageusement collé à la surface extérieure de l'isolant en verre 4 en assurant une conduction électrique à l'aide par exemple d'une colle époxy chargée en argent ou en cuivre.

L'élément protecteur 10 est en matériau souple élastique et isolant électriquement, par exemple en silicone HTV ou en éthylène-propylène diène monomère (EPDM) .

Comme visible sur la figure 3B, la circonférence extérieure du bas de la douille de l'élément protecteur 10 présente une gorge d'angle 10C sur sa périphérie extérieure dans laquelle est logé l'anneau 8.

L'anneau 8 peut être collé dans cette gorge d'angle 10C.

La face inférieure plane de l'anneau 8 est affleurant avec la base de la douille 10A de l'élément protecteur 10.

L'élément protecteur 10 peut être emmanché sur le capot 7 suivant la flèche F illustrée figure 2 jusqu'à ce que son bord inférieur soit en butée contre l'isolant en verre 4.

L'élément protecteur 10 peut être emmanché de préférence avec l'anneau 8 collé dans la gorge d'angle 10C.

Le bord annulaire inférieur de l'élément de protecteur 10 peut également être collé comme l'anneau 8 à la surface extérieure de l'isolant en verre 4 pour empêcher des infiltrations d'eau depuis le capot 7 en direction de l'anneau 8.

L'élément protecteur 10 peut également être en plusieurs parties, par exemple avec une douille 10A en deux parties semi-cylindriques, qui peuvent être posées séparément autour du capot 7 et collées entre elles postérieurement.

Cet agencement peut être avantageux pour une pose de l'élément protecteur 10 en seconde monte sur un isolateur 1 en place sur un pylône.

Par ailleurs, la collerette 10B de l'élément protecteur 10 est profilée en tronc de cône comme visible sur la figure 3B pour que la partie inférieure de la collerette reste sèche et donc isolante quelles que soient les conditions climatiques.

En particulier, l'eau de pluie peut ruisseler naturellement par gravité sur la partie supérieure en tronc de cône de la collerette sans atteindre la partie inférieure de la collerette.

Sur les figures 3A et 3B, on a illustré le câble électrique 11 qui part de l'anneau 8 et qui traverse la collerette 10B de l'élément protecteur 10 pour remonter le long du capot 7 et se raccorder au boitier 9 déporté.

Le trou dans la collerette 10B traversé par le câble électrique 11 sera avantageusement fermé avec du silicone de sorte que le câble 11 traverse de façon étanche la collerette 10B.

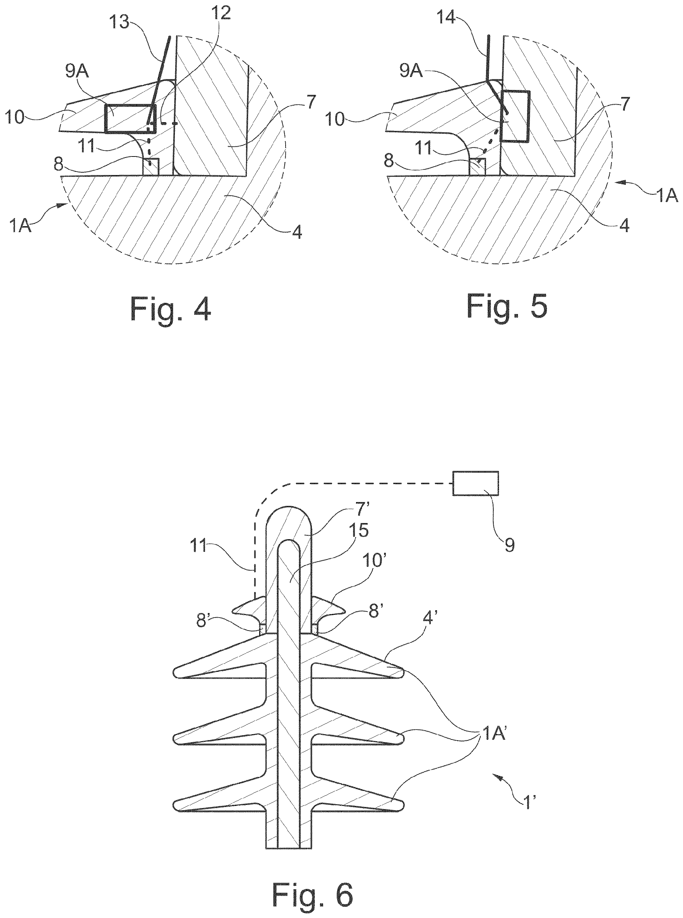

Sur la figure 4, l'anneau 8 est raccordé électriquement à un convertisseur 9A du courant de fuite en tension. Le convertisseur 9A est ici noyé dans l'épaisseur de la collerette 10B de l'élément protecteur 10.

Le convertisseur 9A est relié à la terre par le câble 12 à travers le capot métallique 7 et le signal de tension est conduit depuis le convertisseur 9A par le câble électrique 13 à distance de l'isolateur 1.

Sur la figure 5, le convertisseur 9A est incrusté en surface dans le capot 7 relié à la terre et est recouvert par l'élément protecteur 10. Il fournit le signal de tension sur le câble électrique 14 qui traverse la collerette 10B de l'élément protecteur 10.

Comme indiqué plus haut, l'invention s'applique aussi à un isolateur composite 1' illustré en coupe axiale sur la figure 6.

Cet isolateur composite 1' peut aussi servir à suspendre une ligne électrique 2 aérienne.

L'isolateur composite 1' comprend ici une série d'éléments diélectriques 1A' en matériau synthétique comme de l'EPDM ou du silicone disposés autour d'un jonc 15 formant une âme en fibre de verre. Ces éléments diélectriques 1A' forment des ailettes le long du jonc et globalement chaque ailette à la forme d'une jupe.

Les éléments diélectriques 1A' peuvent être du type moulés directement sur le jonc 15 ou encore empilés sur le jonc 15.

L'élément diélectriques 1A' d'extrémité est prolongé par une armature métallique d'accrochage 7' à un pylône 3 par exemple. Cette armature métallique 7' est ici fixée à l'extrémité du jonc 15.

Comme visible sur la figure 6, l'armature 7' est entourée à distance par un anneau métallique 8' et est protégé par un élément protecteur 10' en forme de douille à collerette qui est de forme analogue à l'élément protecteur 10 des figures 2 à 5.

On a représenté sur la figure 6 un boitier électronique 9 de détection et de mesure d'un signal de fuite superficiel raccordé par le câble électrique 11 à l'anneau 8 conducteur.

## Revendications

1. Isolateur pour lignes électriques aériennes comprenant un élément diélectrique (4, 4') d'extrémité ayant une surface extérieure en forme de jupe et qui est prolongé axialement par une armature métallique (7, 7') d'accrochage de l'isolateur, et un dispositif de détection de courant électrique de fuite superficiel circulant sur ladite surface extérieure dudit élément diélectrique comprenant un anneau (8) métallique en contact électrique avec ladite surface extérieure dudit élément diélectrique (4, 4') pour intercepter ledit courant de fuite superficiel, **caractérisé en ce qu'**il comprend un élément protecteur (10) isolant électriquement en forme de douille à collerette, ladite douille dudit élément protecteur étant interposée entre ledit anneau (8) et ladite armature (7, 7') et ladite collerette dudit élément protecteur s'étendant radialement pour surplomber ledit anneau (8) de façon à former une ombrelle de protection.

2. Isolateur pour lignes électriques aériennes selon la revendication 1, dans lequel ledit anneau (8) est collé à ladite surface extérieure en forme de jupe dudit élément diélectrique avec une colle conductrice de courant.

3. Isolateur pour lignes électriques aériennes selon la revendication 1 ou 2, dans lequel ledit élément protecteur (10) est en éthylène-propylène diène monomère (EPDM) ou en silicone.

4. Isolateur pour lignes électriques aériennes selon l'une des revendications 1 à 3, dans lequel ledit dispositif de détection comprend un convertisseur (9A) du courant de fuite en tension.

5. Isolateur pour lignes électriques aériennes selon la revendication 4, dans lequel ledit convertisseur (9A) est noyé dans ledit élément protecteur (10).

6. Isolateur pour lignes électriques aériennes selon la revendication 4, dans lequel ledit convertisseur (9A) est noyé dans ladite armature métallique.

7. Isolateur pour lignes électriques aériennes selon la revendication 4, dans lequel ledit convertisseur (9A) est déporté dudit isolateur.

8. Isolateur pour lignes électriques aériennes selon l'une des revendications 1 à 7, dans lequel ledit élément diélectrique (4) est en verre.

9. Isolateur pour lignes électriques aériennes selon l'une des revendications 1 à 7, dans lequel ledit élément diélectrique (4) est en porcelaine.

10. Isolateur pour lignes électriques aériennes selon l'une des revendications 1 à 7, dans lequel ledit élément diélectrique (4') est en matériau synthétique.

11. Isolateur pour lignes électriques aériennes selon l'une des revendications précédentes, dans lequel ladite collerette (10B) dudit élément diélectrique (4, 4') a une forme tronconique.

12. Isolateur pour lignes électriques aériennes selon l'une des revendications précédentes, dans lequel ladite collerette (10B) dudit élément protecteur est traversée de façon étanche par un câble électrique (11) relié audit anneau (8).

## Patentansprüche

1. Isolator für elektrische Oberleitungen, der ein dielektrisches Endelement (4, 4') umfasst, das eine äußere Oberfläche in Glockenform hat, und das axial von einer Metallarmatur (7, 7') zum Anhängen des Isolators verlängert ist, und eine Detektionsvorrichtung für Kriechstrom, der auf der äußeren Oberfläche des dielektrischen Elements fließt, die einen metallischen Ring (8) in elektrischem Kontakt mit der äußeren Oberfläche des dielektrischen Elements (4, 4') umfasst, um den Kriechstrom abzufangen, **dadurch gekennzeichnet, dass** er ein elektrisch isolierendes Schutzelement (10) in Hülsenform mit Bund umfasst, wobei die Hülse des Schutzelements zwischen den Ring (8) und die Armatur (7, 7') eingefügt ist, und der Bund des Schutzelements sich radial erstreckt, um über dem Ring (8) derart zu sitzen, dass ein Schutzschirm gebildet wird.

2. Isolator für elektrische Oberleitungen nach Anspruch 1, wobei der Ring (8) an die äußere Oberfläche in Glockenform des dielektrischen Elements mit einem stromleitenden Klebstoff geklebt ist.

3. Isolator für elektrische Oberleitungen nach Anspruch 1 oder 2, wobei das Schutzelement (10) aus Ethylenpropylendienmonomer (EPDM) oder aus Silikon besteht.

4. Isolator für elektrische Oberleitungen nach einem der Ansprüche 1 bis 3, wobei die Detektionsvorrichtung einen Kriechstrom-Wandler (9A) umfasst.

5. Isolator für elektrische Oberleitungen nach Anspruch 4, wobei der Wandler (9A) in das Schutzelement (10) eingelassen ist.

6. Isolator für elektrische Oberleitungen nach Anspruch 4, wobei der Wandler (9A) in die metallische Armatur eingelassen ist.

7. Isolator für elektrische Oberleitungen nach Anspruch 4, wobei der Wandler (9A) von dem Isolator versetzt ist.

8. Isolator für elektrische Oberleitungen nach einem der Ansprüche 1 bis 7, wobei das dielektrische Element (4) aus Glas besteht.

9. Isolator für elektrische Oberleitungen nach einem der Ansprüche 1 bis 7, wobei das dielektrische Element (4) aus Porzellan besteht.

10. Isolator für elektrische Oberleitungen nach einem der Ansprüche 1 bis 7, wobei das dielektrische Element (4') aus synthetischem Material besteht.

11. Isolator für elektrische Oberleitungen nach einem der vorhergehenden Ansprüche, wobei der Bund (10B) des dielektrischen Elements (4, 4') eine Kegelstumpfform hat.

12. Isolator für elektrische Oberleitungen nach einem der vorhergehenden Ansprüche, wobei der Bund (10B) des Schutzelements auf dichte Art von einem elektrischen Kabel (11), das mit dem Ring (8) verbunden ist, durchquert ist.

## Claims

1. An insulator for overhead power lines, the insulator comprising both an end dielectric element (4, 4') having an outside surface in the shape of a skirt and extended axially by a metal attachment fitting (7, 7') for attaching the insulator, and also a device for detecting surface leakage electric current flowing on said outside surface of said dielectric element, the device comprising a metal ring (8) electrically in contact with said outside surface of said dielectric element (4, 4') in order to intercept said surface leakage current, the insulator being **characterized in that** it further comprises an electrically insulating protective element (10) in the form of a collared bushing, said bushing of said protective element being interposed between said ring (8) and said fitting (7, 7'), and said collar of said protective element extending radially to overlie said ring (8) so as to form a protective umbrella.

2. An overhead power line insulator according to claim 1, in which said ring (8) is adhesively-bonded to said outside surface in the shape of a skirt of said dielectric element with an electrically conductive adhesive.

3. An overhead power line insulator according to claim 1 or claim 2, in which said protective element (10) is made of ethylene-propylene-diene monomer (EPDM) or of silicone.

4. An overhead power line insulator according to any one of claims 1 to 3, in which said detector device comprises a converter (9A) for converting the leakage current into voltage.

5. An overhead power line insulator according to claim 4, in which said converter (9A) is embedded in said protective element (10).

6. An overhead power line insulator according to claim 4, in which said converter (9A) is embedded in said metal fitting.

7. An overhead power line insulator according to claim 4, in which said converter (9A) is remote from said insulator.

8. An overhead power line insulator according to any one of claims 1 to 7, in which said dielectric element (4) is made of glass.

9. An overhead power line insulator according to any one of claims 1 to 7, in which said dielectric element (4) is made of porcelain.

10. An overhead power line insulator according to any one of claims 1 to 7, in which said dielectric element (4') is made of synthetic material.

11. An overhead power line insulator according to any preceding claim, in which said collar (10B) of said dielectric element (4, 4') is frustoconical in shape.

12. An overhead power line insulator according to any preceding claim, in which said collar (10B) of said protective element has an electric cable (11) that is connected to said ring (8) passing therethrough in leaktight manner.
